(19) Europäisches Patentamt
European Patent Office
Office européen des brevets

(11) **EP 0 591 113 B1**

(12) **EUROPEAN PATENT SPECIFICATION**

(45) Date of publication and mention
of the grant of the patent:
**30.07.1997 Bulletin 1997/31**

(51) Int Cl.$^6$: **G01D 5/14**, H01L 43/06

(21) Application number: **93830394.8**

(22) Date of filing: **27.09.1993**

(54) **Magnetic position sensor**

Magnetischer Positionsgeber

Capteur de position magnétique

(84) Designated Contracting States:
**DE ES FR GB IT SE**

(30) Priority: **30.09.1992 EP 92830544**

(43) Date of publication of application:
**06.04.1994 Bulletin 1994/14**

(73) Proprietor: **SGS-THOMSON
MICROELECTRONICS s.r.l.
20041 Agrate Brianza (Milano) (IT)**

(72) Inventors:
• **Murari, Bruno
I-20052 Monza (IT)**
• **Storti, Sandro
I-20099 Sesto San Giovanni (IT)**
• **Villa, Flavio
I-20159 Milano (IT)**

(74) Representative: **Cerbaro, Elena et al
STUDIO TORTA S.r.l.,
Via Viotti, 9
10121 Torino (IT)**

(56) References cited:
**EP-A- 0 427 882        US-A- 4 728 950**

• **PATENT ABSTRACTS OF JAPAN vol. 12, no. 314
(E-649)(3161) 25 August 1988 & JP-A-63 079 386
(DAIDO STEEL CO LTD) 9 April 1988**
• **IBM TECHNICAL DISCLOSURE BULLETIN vol.
22, no. 9, February 1980, ARMONK, NEW YORK,
USA pages 4006 - 4008 S.S. HEGEDUS
'Piezoresistive stress independent Hall device'**
• **PATENT ABSTRACTS OF JAPAN vol. 12, no. 377
(P-768)7 October 1988 & JP-A-63 122 911 (KOBE
STEEL LTD.) 26 May 1988**

## Description

The present invention relates to a position sensor.

For detecting the position of an object, transducers based on various principles are currently available, some of which exploit the Hall effect, whereby, if a conductor material through which current flows in one direction is immersed in a magnetic field directed perpendicular to the current flow direction, across the sensor an electric field is observed perpendicular to both the current and the magnetic field and proportional to the strength of the magnetic field at that point.

Consequently, on known Hall-effect transducers, by measuring the difference in potential across the sensor, it is possible to determine the position of a magnetic element (e.g. a permanent magnet or magnetic circuit) whose field pattern is known.

Generally speaking, as the magnetic field of the permanent magnet or magnetic circuit employed is variable in space, currently used sensors only provide for accurately determining its position when the magnetic element is movable solely in a given straight line (normally parallel or perpendicular to the sensor). Any unpredictable component in the movement of the magnetic element therefore introduces measuring errors, thus impairing the reliability and limiting the scope of known Hall-effect transducers.

Further limitations are posed by the sensitivity of Hall-effect transducers to any misalignment of the magnetic element and sensor, and to variations in the quantities affecting the transfer constant, such as supply voltage and current, and the characteristics of the sensor (e.g. in the case of solid-state sensors, carrier mobility in turn dependent on temperature). As a result, known transducers involve mechanical alignment, electrical calibration, and highly complex circuitry for compensating for variations in operating conditions (e.g. in temperature), which provisions, however, do not always succeed in achieving the desired accuracy and reliability of the transducer.

To solve the above problems, it is known to employ an array of elementary sensors of the Hall type for determining the zero point of a magnetic field component and generating directly at the output a numeric code indicating the zero point position (see, e.g. EP-A-0 427 882).

Moreover, it is known to integrate a single Hall effect cell in an integrated circuit (see e.g. G. Bosch, "A Hall device in an integrated circuit", Solid State Electron, vol. 11, pages 712 to 714, 1968; G.S. Randhawa "Monolithic integrated Hall devices in silicon circuits", Microelectron. Journal, vol 12, pages 24 to 29, 1981).

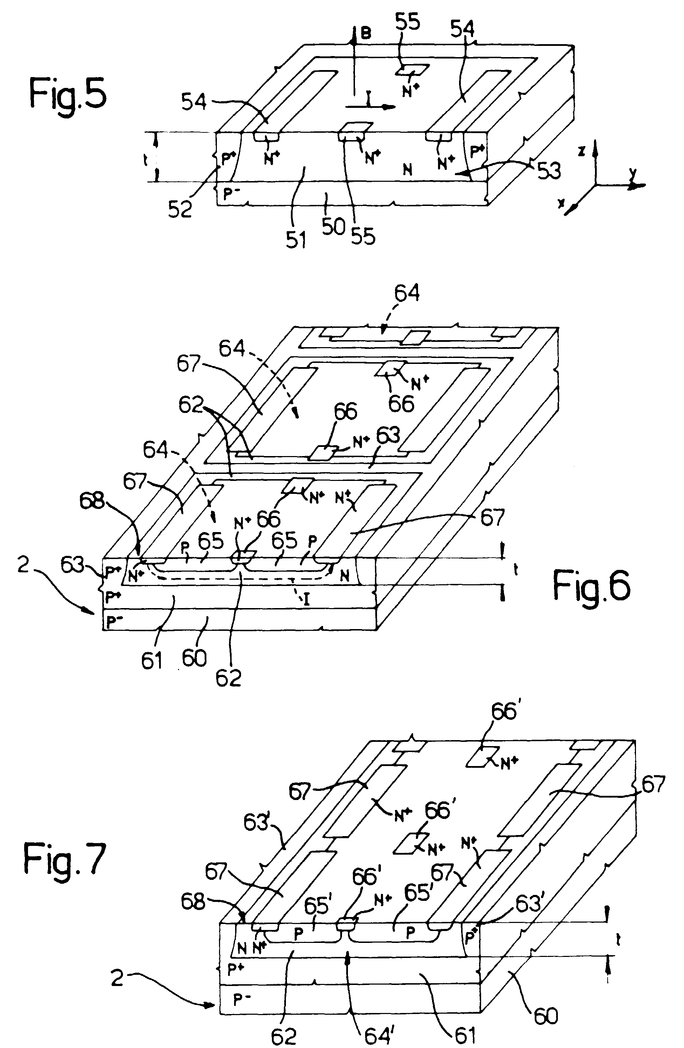

Accordingly, a number of commercial products was developed, having the structure shown in fig. 5, including a substrate 50 (preferably of P -type), an epitaxial layer 51 of N-type, having a depth t, an isolation region 52 of P+-type, formed in the epitaxial layer 51 and delimiting an active region 53, contacts 54, 55 of N+-type formed during the emitter diffusion step of the integrated circuit. The Hall voltage $V_H$ of such cell is:

$$V_H = G \frac{B\,I}{qNt} \qquad (1)$$

wherein G is a geometrical correction factor due to the finite dimensions of the cell (G = 1, by conveniently dimensioning the cell), N is the concentration of doping species of the epitaxial layer, t is the depth of the epitaxial layer, and B is the component of the magnetic induction which is perpendicular to the current I.

Pat. Abst. of Japan vol. 12, no 314 25.8.88 and JP-A-63-79386 disclose a Hall element array, wherein the Hall elements are formed on a semiconductor chip of Ga-As. Furthermore, in IBM Techn. Discl. Bull. V. 22, No.9, 1980, p. 4006-4008 a Hall device is disclosed, having two Hall sensor regions integrated in an epitaxial layer.

The problem in integrating Hall-effect sensors in a single chip including conventional electronic components consists in that not always the resistivity of the epitaxial layer of integrated circuits has the value which is optimal for obtaining the requested sensitivity and efficiency and, on the other hand, conventional techniques for modifying the resistivity to obtain the requested values imply ad hoc processes or manufacturing steps.

It is an object of the present invention to provide a position sensor which has a high degree of reliability and is simple and cheap to manufacture, using well known manufacturing steps.

According to the present invention, there is provided a position sensor as claimed in Claim 1.

Preferred embodiments of the present invention will be described by way of example with reference to the accompanying drawings, in which:

Fig. 1 shows a perspective view of a transducer-encoder including the sensor according to the present invention;

Fig. 2 is a schematic cross section of the sensor of Fig. 1 taken along line II-II;

Fig. 3 shows a different embodiment of a detail of the transducer if Fig. 1;

Fig. 4 shows a different embodiment of the sensor of Fig. 2;

Fig. 5 shows the implementation of a known integrated Hall cell; and

Figs. 6 and 7 show two different embodiments of the implementation of the present sensor in a broken perspective view.

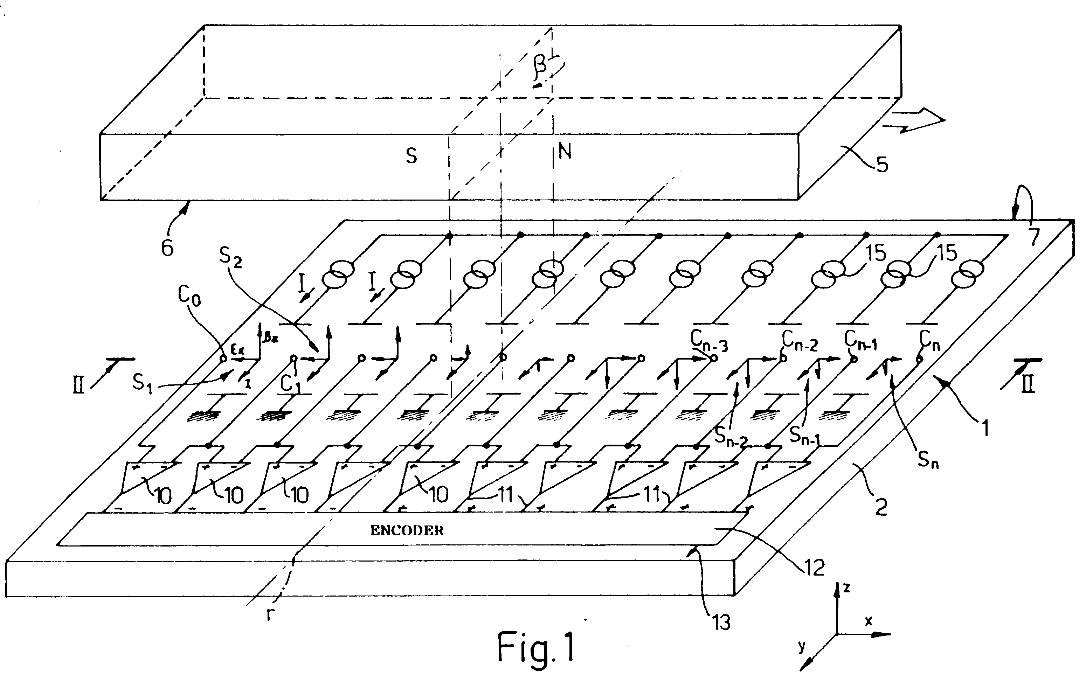

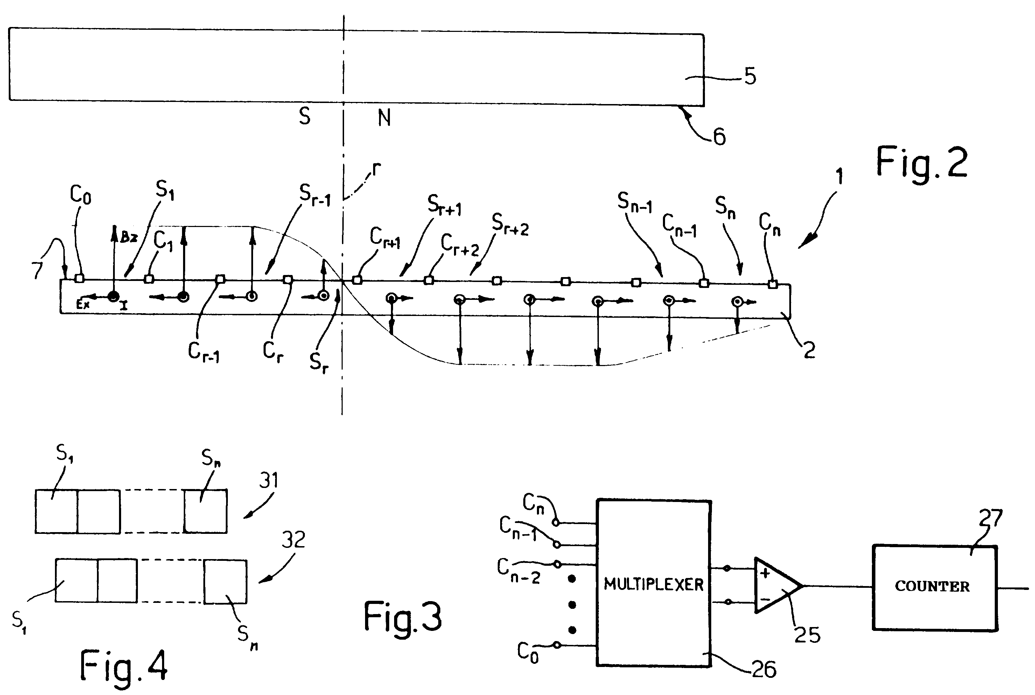

The principle underlying the present invention will be described firstly with reference to Figs. 1 and 2 wherein number 1 indicates a solid-state type sensor formed in a chip 2 of semiconductor material (typically silicon). As shown, sensor 1 comprises a plurality of el-

ementary sensors $S_1$, $S_2$, ... $S_i$, $S_{i+1}$, ... $S_n$, aligned side by side in one direction (hereinafter referred to as the X axis) and each supplied with current I directed perpendicular to the X axis, in the direction indicated by the Y axis (perpendicular to the Fig.2 plane). Each elementary sensor $S_i$ presents a pair of contacts $C_{i-1}$, $C_i$, also aligned along the X axis and shared respectively with the foregoing sensor $S_{i-1}$ and the following sensor $S_{i+1}$.

Sensor 1 is located in a magnetic field generated by a permanent magnet 5 in the form of an elongated bar, the north and south poles N and S of which are formed on face 6 looking toward surface 7 of sensor 1 (which defines the X, Y plane and on which elementary sensors $S_i$ are arranged). Permanent magnet 5 and the line joining the N and S poles are arranged parallel to the X axis, so that permanent magnet 5 generates a magnetic field described by magnetic induction $\vec{B}$ whose component perpendicular to the current flow direction and that in which the sensor contacts are aligned (Z axis direction) is zero in one plane. In other words, for permanent magnet 5, there exists a plane $\beta$ (Fig.2) in which magnetic induction component $B_Z$ is zeroed; which plane, parallel to plane Y, Z, may be described by the equation $X = K$, where K is constant, and intercepts surface 7 along line $\underline{r}$ parallel to the Y axis. Though magnetic induction $\vec{B}$ in plane $\beta$ is obviously other than zero, indeed component $B_X$ is maximum, sensors $S_i$ are only sensitive to magnetic induction component $B_Z$.

In fact, due to the very nature of the Hall effect:

$$\vec{E} = q\vec{V} \times \vec{B}$$

wherein $\vec{E}$ is the electric field, q is the electrical charge of the moving particles, $\vec{V}$ is the speed of the moving particles and $\vec{B}$ is the magnetic induction, so that electric field $\vec{E}$ is proportional to vectorial product $\vec{I} \times \vec{B}$ ($\vec{I} = q\vec{V}$).

In the present case, by virtue of contacts $C_i$ being aligned along the X axis, sensors $S_i$ are only sensitive to electric field component $E_X$; and, by virtue of current I being directed parallel to the Y axis, component $E_X$ is proportional to the product of current I and magnetic induction component $B_Z$, i.e.

$$E_X = K_1 I B_Z$$

In the example shown, by virtue of magnetic induction component $B_Z$ (and therefore $E_X$) being zeroed along line $\underline{r}$, as already stated, if $S_r$ is the sensor through which line $\underline{r}$ extends, for all the sensors $S_1$ ... $S_{r-1}$ to the left of sensor $S_r$: $B_Z > 0$ and $E_X > 0$; and, for all the sensors $S_{r+1}$ ... $S_n$ to the right of sensor $S_r$: $B_Z < 0$ and $E_X < 0$.

Consequently, by measuring the difference in potential $DV_i$ between contacts $C_{i-1}$, $C_i$ of each sensor $S_i$

$$DV_i = V_i - V_{i-1} < 0 \text{ when } i < r \text{ and}$$

$$DV_i = V_i - V_{i-1} > 0 \text{ when } i > r$$

When magnet 5 moves parallel to the X axis, plane $\beta$ and consequently line $\underline{r}$ also move rigidly together with magnet 5, thus changing the sensor $S_i$ in which the sign of component $B_Z$ and consequently the detected potential difference $DV_i$ are inverted. Said sensor therefore defines, in each case, the position of plane $\beta$ and, given the crossover line between the north and south poles N and S of magnet 5, the position of magnet 5 in relation to sensor 1. By detecting the point (or sensor) in which the sign of potential difference $DV_i$ is inverted, it is therefore possible to determine the position of magnet 5.

Sensor $S_r$ in which sign inversion of the potential difference occurs may be detected in various ways, one of which is shown by way of example in Fig. 1, wherein each sensor $S_i$ is connected by contacts $C_{i-1}$, $C_i$ to a respective comparator 10, the output 11 of which generates a binary signal referred to ground, the logic value of which depends on the sign of the potential difference between the contacts to which comparator 10 is connected. Outputs 11 are connected to respective inputs of an encoding circuit 12 consisting of combinatory logics and generating, at output 13, a numerical signal proportional to the position of sensor $S_r$.

Fig. 1 also shows, schematically, the current sources 15, one for each sensor $S_i$, for generating currents I.

As shown in Fig.1, elementary sensors $S_i$, current sources 15, comparators 10 and encoding circuit 12 are advantageously integrated in a single chip 2, more specifically, in an epitaxial layer, e.g. of N-type, grown on a P-type substrate, as explained later with reference to figs. 6 and 7.

In the Fig. 1 device, if $\underline{l}$ is the length of chip 2 (in direction X in which sensors $S_i$ and contacts $C_i$ are aligned) corresponding to the maximum position detection range; and $\underline{w}$ is the distance between elementary sensors $S_i$, corresponding substantially to the width of each sensor in the same direction; then $l = nw$, so that the position of magnet 5 is determined discretely in $\underline{n}$ steps with an absolute resolving power of $\underline{w}$ and a relative resolving power of $l/n$. If, for example, $\underline{l} = 4$ mm and $\underline{w} = 200$ μm : $\underline{n} = 20$, with an absolute resolving power of 200 μm and a relative resolving power of 5%.

In other words, the present sensor supplies ready-quantized position information, by virtue of field $\vec{B}$ being sampled in a finite number of points by a finite number of sensors. Therefore, the present sensor is insensitive to the absolute magnetic field strength (absolute magnetic induction value), and consequently to the distance of the magnetic element along the Z axis, providing the field exceeds a minimum value enabling the signal (potential difference) to be distinguished from offset and noise. As such, any nonlinearity of the field strength-distance relationship no longer requires complex logics for processing the signal generated by the sensors.

Furthermore, the sensor is insensitive to any misalignment of the magnet along the X axis (lack of parallelism between the magnet and elementary sensor array), which misalignment generally results in a reduction in the strength of magnetic induction $\vec{B}$, but has no affect on the X coordinate at which component $B_Z$ is zeroed, so that the sensor only measures the variation in position along the X axis.

The sensor is also insensitive to variations in quantities affecting the transfer constant of Hall-effect sensors, such as supply voltage and current, mobility of the carriers in the semiconductor material, and temperature (which affects the above parameters) and is insensitive to any nonlinearity, typical of Hall-effect sensors, between position and the detected potential difference.

Therefore the need is eliminated for mechanical alignment and electrical calibration, so greatly simplifying and reducing the cost of installation, manufacture and operation (e.g. by means of appropriate processing routines) for compensating for factors which impair or at least reduce the reliability of known analog sensors. Moreover, the present sensor is extremely stable as regards variations in temperature and supply voltage, as well as aging.

Being ready-quantized, the output of the present sensor is immediately processable using binary logics, with no conversion required, thus affording advantages in terms of circuitry and processing time.

To those skilled in the art it will be clear that changes may be made to the sensor and relative transducer as described and illustrated herein.

More specifically, the logics for detecting and processing the voltage signal generated by the elementary sensors may vary considerably as compared with those described herein. For example, as shown in Fig. 3, a single comparator 25 may be employed, the two inputs of which are time-share-multiplexed to pairs of contacts $C_{i-1}$, $C_i$ of elementary sensors $S_i$ via a multiplexer 26; and a counter 27 for counting, for example, the number of high states at the output of comparator 25, presents, for each complete scan of the sensor array, a count proportional to the position of the magnet. In this case also, comparator 25, multiplexer 26 and counter 27 may be integrated in the same chip of sensor 1.

The elementary sensors may also be mutually isolated, or not, since the currents in the sensors present no components along the X axis. Moreover, the adjacent contacts of adjacent elementary sensors need not necessarily be shortcircuited (especially if the elementary sensors are mutually isolated as mentioned above), in which case, each comparator may be connected solely to a respective pair of contacts; or each elementary sensor may present a first contact connected to the input of a first multiplexer, and the other contact connected to the input of a second multiplexer, with the outputs of the two multiplexers connected to the two inputs of a comparator similar to 25 in Fig.3. In this case, the increase in the number of connections is offset by greater freedom in optimization of the sensors.

Two possible implementations with isolated and non-isolated elementary sensors are shown in figs. 6 and 7 and described hereinbelow. The sensor of fig. 6 comprises a substrate 60 of the $P^-$-type; a bottom isolation region 61, of the $P^+$-type, covering the entire top surface of the substrate 60; an epitaxial layer 62, of the N-type; a top isolation region 63, of the $P^+$-type, formed in the epitaxial layer and laterally delimiting therein a plurality of active regions 64, each forming an own elementary Hall sensor; base diffusion regions 65 of the P-type, formed in the epitaxial layer and upwardly delimiting the active regions 64; first contact regions 66 of the $N^+$-type forming contacts $C_i$, $C_{i+1}$ of an elementary sensor $S_i$ (two contact regions 66 for each elementary sensor); and second contact regions 67 of the $N^+$-type, two for each elementary sensor, forming contacts for injection of current I. Both first and second contact regions 66, 67 are formed at the edge of base diffusion regions 65 and are directly connected to epitaxial layer 62. Therefore, in the sensor of fig. 6, each elementary sensor $S_i$ is isolated from the adjacent elementary sensors or cells by the isolation region 63, and has own contact regions 66.

In the sensor of fig. 7, the elementary sensors are not isolated from one another, and the contacts $C_i$ are shared with the adjacent sensors. The sensor of fig. 7 thus comprises substrate 60; bottom isolation region 61; epitaxial layer 62; a top isolation region 63', laterally delimiting a single active region 64' forming all (or a group of) elementary sensors $S_i$; a single base diffusion region 65'; first contact regions 66' forming contacts $C_i$, each first contact region 66' of an elementary sensor being shared with the adjacent elementary sensor; and a pair of second contact regions 67 for each elementary sensor $S_i$.

In both implementations, the depth of the epitaxial layer 62, indicated at $\underline{t}$, is about one half of the depth of the epitaxial layer 51 of the know implementation of fig. 5, being reduced by the bottom isolation region 61 formed by diffusion of P-type dopants into the epitaxial layer from below. Therefore Hall effect voltage $V_H$, defined by equation (1), is doubled, increasing sensor sensitivity. Furthermore, the base diffusion regions 65, 65' have a double function: they eliminate surface effects affecting offset voltage $V_{OS}$ and further increase Hall effect voltage $V_H$ Indeed, base diffusion regions 65, 65' completely isolate the active areas of elementary sensors $S_i$ from the $Si$-$SiO_2$ interface region formed at the upper main surface 68 of the sensor structure of figs. 6 and 7 (which is covered by an oxide layer -not shown-, as per se known). Moreover, the base diffusion regions 65, 65' reduce the depth of epitaxial layer 62, further increasing the value of Hall effect voltage $V_H$. Therefore, with the implementation of figs. 6 and 7, the Hall effect voltage $V_H$ is highly increased.

Both embodiments may be simply and cheaply implemented using known manufacture processes, including the known top-bottom isolation technique (wherein the junction isolation between active areas is obtained in two different implantation steps, one performed before growing the epitaxial layer, for forming, later, the bottom portion of the isolation regions, and the other performed onto the grown epitaxial layer, for forming the top portion of the isolation regions, merging with the bottom portion). Furthermore manufacture of the present sensor does not require additional masks, and thus additional costs. In particular, a possible schematic manufacture step sequence is the following: P$^-$-type substrate 60 is implanted with high-energy P-type doping species, to later form bottom isolation region 61, such implantation being performed both at the areas where lateral isolation regions and the active region(s) of the sensor are to be formed. Thereafter epitaxial layer 62 is grown, P-type doping species are implanted to form top isolation region 63, 63', and base diffusion regions 65, 65' are formed in the same step as base regions of any transistor integrated in the same chip as the sensor (for example to form components 10, 12 of fig. 1). Note that base diffusion regions 65, 65' are obtained using a mask which covers the epitaxial layer at the zones where first contact regions 66, 66' are to be formed; thereby such zones are not diffused with P-type dopants and later allow contiguity between first contact regions 66, 66' and active regions 64, 64', as important in particular for the embodiment of fig. 7. Thereafter, N-type doping species are implanted or diffused to form contacts 66, 66', 67 and usual finishing manufacture steps are performed.

In general, the elementary sensors may be aligned along any flat line lying in plane 7 of chip 2 and parallel to the path of magnet 5, e.g. a line in the form of an arc.

Also, the sensor may comprise more than one plurality of elementary sensors, as shown by way of example in Fig.4, which shows two pluralities 31 and 32 of elementary sensors $S_1$-$S_n$ arranged in two parallel lines offset by w/2, w being the distance between the adjacent elementary sensors in each plurality. Both pluralities may be integrated in the same chip 2. Such an embodiment provides for enhancing resolving power, and, despite increasing (doubling) the current and the space required for integrating the sensor, the maximum dimension (the direction in which the elementary sensors in each plurality are aligned) remains unchanged. Such a solution may obviously be extended to N pluralities of sensors offset by w/N to give a resolving power of w/N and N times the current. Just how many pluralities of elementary sensors are provided is limited theoretically by the possibility of safely detecting the difference in the sign of the magnetic field component detected between two elementary sensors belonging to two different pluralities and offset by w/N.

As for the magnetic element, which does not form part of the present invention, this may be formed in any manner, providing it presents at least one magnetic field component zeroing in at least one point (preferably on a surface), and, more specifically, may consist of a permanent bar magnet, as described, or an appropriate magnetic circuit. Moreover, the useful field component ($B_Z$) and consequently the extent to which it varies about zero may be increased by providing a plate of highly permeable magnetic material in a plane parallel to plane X, Y defined by chip surface 7, and in the opposite half space to that occupied by magnet 5 (in the example shown, underneath chip 2). Alternatively, the same may be achieved using a second magnet, also located in the opposite half space to that of the first magnet, and having its south pole aligned with the north pole of the first magnet and vice versa, in which case, both magnets must move integral with each other in relation to the sensor.

**Claims**

1. A position sensor (1) for detecting the position of a magnetic element (5) generating a magnetic field having at least one component ($B_Z$) zeroing in at least one point in space, the sensor (1) comprising at least one plurality (31; 32) of side by side hall-effect elementary sensors ($S_i$) for detecting the zero point of said magnetic field component ($B_Z$), characterized in that said elementary sensors ($S_i$) are solid-state sensors integrated adjacently to one another in a single chip of a semiconductor body (2) comprising a substrate (60) of a first conductivity type; a bottom isolation region (61), of said first conductivity type, overlying said substrate; an epitaxial layer (62) of a second opposed conductivity type, overlying said bottom isolation region, said epitaxial layer defining an upper large face (68) of said semiconductor body; a top isolation region (63, 63'), of said second opposed conductivity type, grown into said epitaxial layer and laterally delimiting at least one active region (64, 64') in said epitaxial layer; an interface isolation region (65, 65') of said first conductivity type grown into said epitaxial layer and isolating said active region in said epitaxial layer from said upper large face; and contact regions (66, 66', 67) of said second opposed conductivity type in direct contact with said active region of said epitaxial layer.

2. A sensor as claimed in Claim 1, comprising zero detecting means (10, 12; 25-27) connected to said elementary sensors ($S_i$) and including position detecting means, said position detecting means generating an output signal indicating the position of one of said elementary sensors ($S_i$) generating an electric output signal opposite in sign to the electric signal generated by one of the two adjacent elementary sensors.

3. A sensor as claimed in Claim 2, wherein said zero detecting means comprise a number of comparators (10), each connected to a respective elementary sensor ($S_i$) and each having an output (11) supplying a respective logic signal indicating the sign of said magnetic field component ($B_Z$).

4. A sensor as claimed in Claim 3, comprising an encoder circuit (12) connected to said outputs (11) of said comparators (10) and generating at the output (13) a quantized position signal coding the position of said magnetic element (5) in relation to said position sensor (1).

5. A sensor as claimed in Claim 2, wherein said zero detecting means comprise a multiplexing element (26) having a number of inputs connected to said elementary sensors ($S_i$), and an output; a comparator (25) having an input connected to said output of said multiplex' ing element; and a counter (27) connected to the output of said comparator.

6. A sensor as claimed in any one of the foregoing Claims, wherein said elementary sensors ($S_i$) are aligned in a flat line and each elementary sensor presents a pair of contacts ($C_{i-1}$, $C_i$).

7. A sensor as claimed in Claim 6, wherein each contact ($C_{i-1}$, $C_i$) of one elementary sensor ($S_i$) is connected to a contact of an adjacent elementary sensor ($S_{i-1}$, $S_{i+1}$).

8. A sensor as claimed in any one of the foregoing Claims, comprising a second plurality (32) of elementary sensors ($S_1$-$S_n$) extending close and parallel to, and offset with respect to said at least one plurality (31) of elementary sensors.

9. A sensor as claimed in Claim 1, wherein each elementary sensor ($S_i$) comprises an own active region (64) and the active regions of adjacent elementary sensors are isolated from each other by portions of said top isolation region (63).

10. A sensor as claimed in Claim 1, comprising a single active region (64') forming said elementary sensors.

11. A sensor as claimed in Claim 1, wherein said at least some (66, 66') of said contact regions are arranged at windows of said interface isolation region (65, 65') and extend toward said epitaxial layer (62) to directly contact said epitaxial layer.

**Patentansprüche**

1. Positionssensor (1) zum Ermitteln der Position eines Magnetelements (5), das ein Magnetfeld erzeugt, das wenigstens eine Komponente ($B_Z$) aufweist, das in wenigstens einem Punkt im Raum zu Null wird, wobei der Sensor (1) wenigstens eine Mehrzahl (31; 32) von nebeneinanderliegenden Halleffekt-Elementarsensoren ($S_i$) aufweist, um den Null-Punkt der Magnetfeldkomponente ($B_Z$) zu ermitteln, dadurch gekennzeichnet, daß die Elementarsensoren ($S_i$) Festkörpersensoren sind, die benachbart zueinander in einem einzigen Chip eines Halbleiterkörpers (2) integriert sind, der ein Substrat (60) von einem ersten Leitfähigkeits-Typ aufweist, einen unteren Isolationsbereich (61) vom ersten Leitfähigkeits-Typ, der über dem Substrat liegt, eine epitaxiale Schicht (62) von einem zweiten entgegengesetzten Leitfähigkeits-Typ, die über dem unteren Isolationsbereich liegt, wobei die epitaxiale Schicht eine obere große Fläche (68) des Halbleiterkörpers festlegt, einen oberen Isolationsbereich (63, 63') vom zweiten entgegengesetzten Leitfähigkeits-Typ, der in die expitaxiale Schicht eingewachsen ist und seitlich wenigstens einen aktiven Bereich (64, 64') in der epitaxialen Schicht begrenzt, einen Grenzflächenisolationsbereich (65, 65') vom ersten Leitfähigkeits-Typ, der in die epitaxiale Schicht eingewachsen ist und den aktiven Bereich in der epitaxialen Schicht von der oberen großen Fläche isoliert, und Kontaktbereiche (66, 66', 67) vom zweiten entgegengesetzten Leitfähigkeits-Typ in direktem Kontakt mit dem aktiven Bereich der epitaxialen Schicht.

2. Sensor nach Anspruch 1, aufweisend eine Null-Ermittlungseinrichtung (10, 12; 25-27), die mit den Elementarsensoren ($S_i$) verbunden ist und eine Positionsermittlungseinrichtung aufweist, wobei die Positionsermittlungseinrichtung ein Ausgangssignal erzeugt, das die Position von einem der Elementarsensoren ($S_i$) anzeigt, der ein elektrisches Ausgangssignal erzeugt, das ein entgegengesetztes Vorzeichen zu dem elektrischen Signal hat, das durch einen der zwei benachbarten Elementarsensoren erzeugt wird.

3. Sensor nach Anspruch 2, wobei die Null-Ermittlungseinrichtung eine Anzahl von Komparatoren (10) aufweist, von denen jeder mit einem jeweiligen Elementarsensor ($S_i$) verbunden ist und jeweils einen Ausgang (11) aufweist, der ein jeweiliges Logiksignal zuführt, welches das Vorzeichen der Magnetfeldkomponente ($B_Z$) anzeigt.

4. Sensor nach Anspruch 3, aufweisend eine Kodierschaltung (12), die mit den Ausgängen (11) der Komparatoren (10) verbunden ist und am Ausgang (13) ein quantisiertes Positionssignal erzeugt, das die Position des Magnetelements (5) in Bezug auf den Positionssensor (1) kodiert.

**5.** Sensor nach Anspruch 2, wobei die Null-Ermittlungseinrichtung ein Multiplexierelement (26) aufweist, das eine Anzahl von Eingängen hat, die mit den Elementarsensoren ($S_i$) verbunden sind, und einen Ausgang, einen Komparator (25), der einen Eingang aufweist, der mit dem Ausgang des Multiplexierelements verbunden ist, und einen Zähler (27), der mit dem Ausgang des Komparators verbunden ist.

**6.** Sensor nach einem der vorangehenden Ansprüche, wobei die Elementarsensoren ($S_i$) in einer flachen Linie ausgerichtet sind, wobei jeder Elementarsensor ein Paar von Kontakten ($C_{i-1}$, $C_i$) aufweist.

**7.** Sensor nach Anspruch 6, wobei jeder Kontakt ($C_{i-1}$, $C_i$) von jedem Elementarsensor ($S_i$) mit einem Kontakt eines benachbarten Elementarsensors ($S_{i-1}$, $S_{i+1}$) verbunden ist.

**8.** Sensor nach einem der vorangehenden Ansprüche, aufweisend eine zweite Mehrzahl (32) von Elementarsensoren ($S_1$-$S_n$), die sich nahe, parallel und versetzt zu der wenigstens einen Mehrzahl (31) von Elementarsensoren erstreckt.

**9.** Sensor nach Anspruch 1, wobei jeder Elementarsensor ($S_i$) einen eigenen aktiven Bereich (64) aufweist, und wobei die aktiven Bereiche von benachbarten Elementarsensoren voneinander durch Abschnitte des oberen Isolationsbereichs (63) isoliert sind.

**10.** Sensor nach Anspruch 1, aufweisend einen einzigen aktiven Bereich (64'), der die Elementarsensoren bildet.

**11.** Sensor nach Anspruch 1, wobei wenigstens einige (66, 66') der Kontaktbereiche an bzw. in Fenstern des Grenzflächenisolationsbereichs (65, 65') angeordnet sind und sich in Richtung auf die epitaxiale Schicht (62) erstrecken, um die epitaxiale Schicht direkt zu kontaktieren.

**Revendications**

**1.** Détecteur de position pour détecter la position d'un élément magnétique (5) produisant un champ magnétique ayant au moins une composante ($B_Z$) passant à zéro dans au moins un point de l'espace, le détecteur (1) comprenant au moins une première pluralité (31, 32) de capteurs élémentaires à effet Hall côte à côte ($S_i$) pour détecter le point zéro de la composante de champ magnétique ($B_Z$), caractérisé en ce que les détecteurs élémentaires ($S_i$) sont des détecteurs statiques intégrés de façon voisine l'un de l'autre dans une puce unique d'un corps semiconducteur (2) comprenant un substrat (60) d'un premier type de conductivité ; une région d'isolement de fond (61) du premier type de conductivité recouvrant le substrat ; une couche épitaxiale (62) d'un second type de conductivité opposé recouvrant la région d'isolement de fond, la couche épitaxiale définissant une grande face supérieure (68) du corps semiconducteur ; une région d'isolement supérieur (63, 63') du second type de conductivité opposé amenée à croître dans la couche épitaxiale et délimitant latéralement au moins une région active (64, 64') dans la couche épitaxiale ; une région d'isolement d'interface (65, 65') du premier type de conductivité amenée à croître dans la couche épitaxiale et isolant la région active de la couche épitaxiale de la grande face supérieure ; et des régions de contact (66, 66', 67) du second type de conductivité opposé en contact direct avec la région active de la couche épitaxiale.

**2.** Détecteur selon la revendication 1, comprenant un moyen de détection de zéro (10, 12 ; 25-27) connecté aux détecteurs élémentaires ($S_i$) et comprenant un moyen de détection de position, le moyen de détection de position produisant un signal de sortie indiquant la position de l'un des détecteurs élémentaires ($S_i$) produisant un signal de sortie électrique de signe opposé au signal électrique produit par l'un des deux détecteurs adjacents.

**3.** Détecteur selon la revendication 2, dans lequel le moyen de détection de zéro comprend plusieurs comparateurs (10) dont chacun est connecté à un détecteur élémentaire respectif ($S_i$) et ayant chacun une sortie (11) fournissant un signal logique respectif indiquant le signe de la composante de champ magnétique ($B_Z$).

**4.** Détecteur selon la revendication 3, comprenant un circuit codeur (12) connecté aux sorties (11) des comparateurs (10) et produisant sur la sortie (13) un signal de position quantifié codant la position de l'élément magnétique (5) par rapport au détecteur de position (1).

**5.** Détecteur selon la revendication 2, dans lequel le moyen de détection de zéro comprend un élément de multiplexage (26) ayant plusieurs entrées connectées aux détecteurs élémentaires ($S_i$) et une sortie ; un comparateur (25) ayant une entrée connectée à la sortie de l'élément de multiplexage ; et un compteur (27) connecté à la sortie du comparateur.

**6.** Détecteur selon l'une quelconque des revendications précédentes, dans lequel les détecteurs élémentaires ($S_i$) sont alignés dans un plan et chaque détecteur élémentaire a une paire de contacts ($C_{i-1}$,

$C_i$).

7. Détecteur selon la revendication 6, dans lequel chaque contact ($C_{i-1}$, $C_i$) d'un détecteur élémentaire ($S_i$) est connecté à un contact d'un détecteur élémentaire adjacent ($S_{i-1}$, $S_{i+1}$).

8. Détecteur selon l'une quelconque des revendications précédentes, comprenant une deuxième pluralité (32) de détecteurs élémentaires ($S_1$-$S_n$) s'étendant près de ladite au moins une pluralité (31) de détecteurs élémentaires et étant parallèle à ceux-ci et décalé par rapport à ceux-ci.

9. Détecteur selon la revendication 1, dans lequel chaque détecteur élémentaire ($S_i$) comprend sa propre région active (64), les régions actives des détecteurs élémentaires voisins étant isolées les unes des autres par des parties de la région d'isolement supérieure (63).

10. Détecteur selon la revendication 1, comprenant une région active unique (64') formant les détecteurs élémentaires.

11. Détecteur selon la revendication 1, dans lequel lesdites au moins certaines (66, 66') des régions de contact sont disposées au niveau de fenêtres de la région d'isolement d'interface (65, 65') et s'étendent vers la couche épitaxiale (62) pour contacter directement la couche épitaxiale.

EP 0 591 113 B1

Fig.1

Fig.2

Fig.3

Fig.4

COUNTER

MULTIPLEXER

Fig.5

Fig.6

Fig.7